Europäisches Patentamt

European Patent Office

Office européen des brevets

(19)

(11) Publication number: **0 036 775**
**B1**

## EUROPEAN PATENT SPECIFICATION

(12)

(45) Date of publication of patent specification: **03.12.86**

(51) Int. Cl.⁴: **G 11 C 7/00, G 11 C 11/40**

(21) Application number: **81301224.2**

(22) Date of filing: **23.03.81**

(54) **Static memory circuit.**

(30) Priority: **26.03.80 JP 38537/80**

(43) Date of publication of application:
**30.09.81 Bulletin 81/39**

(45) Publication of the grant of the patent:
**03.12.86 Bulletin 86/49**

(84) Designated Contracting States:
**DE FR GB**

(56) References cited:
**US-A-3 621 302**

**IBM TECHNICAL DISCLOSURE BULLETIN, vol.
17, no. 11, April 1975, page 3336, New York
(USA); R.G.GLADU et al : " Multigated "Dribble"
powered MOS FET storage cell."**

**IBM TECHNICAL DISCLOSURE BULLETIN, vol.
17, no. 11, April 1975, page 3337, New York
(USA); G.Y.SONODA : "IGFET address
powered Schmidt storage cell"**

**PATENTS ABSTRACTS OF JAPAN, vol. 4, no.
153, 25th October 1980, page 84 P 33;**

(73) Proprietor: **FUJITSU LIMITED**
**1015, Kamikodanaka Nakahara-ku
Kawasaki-shi Kanagawa 211 (JP)**

(72) Inventor: **Kurafuji, Setsuo
2-5, Edakita 2-chome Midori-ku
Yokohama-shi Kanagawa 227 (JP)**
Inventor: **Tanimoto, Kazuo
2-4-5-307, Suwa Tama-shi
Tokyo, 192-02 (JP)**

(74) Representative: **Sunderland, James Harry et al
HASELTINE LAKE & CO Hazlitt House 28
Southampton Buildings Chancery Lane
London WC2A 1AT (GB)**

## Description

The present invention relates to a static memory circuit incorporating memory cells of a MOS static type.

In general, each of the MOS static memory cells comprises a bi-stable flip-flop which uses four transistors per bit. That is, the memory cell comprises a pair of load resistors, a pair of driver transistors which are cross-coupled to each other, and a pair of transfer gate transistors connected to one word line and one bit line pair. In this memory cell, only one of the driver transistors is turned on to correspond to memory data "0" or "1".

In order to read the cell, the transfer gate transistors are turned on by changing the potential of the word line so that the data on the driver transistors is transferred to the bit lines. Similarly, in order to write data into the cell, the transfer gate transistors are also turned on by changing the potential of the word line and proper voltages are then applied to the bit lines.

One conventional static memory circuit of a MOS static type incorporates a large number of such memory cells arranged along rows and columns which are orthogonal to each other. In addition, the circuit comprises a plurality of word lines each connected to the memory cells belonging to one row, a plurality of pairs of bit lines, each pair connected to the memory cells belonging to one column, and a plurality of pairs of column selection gates each pair connected to one pair of the bit lines. In this case, selection of one cell among the memory cells is effected by selecting one of the word lines and one pair of the bit lines.

However, in the abovementioned conventional circuit, when one memory cell is selected so as to read the data stored in the cell, transfer gate transistors of other non-selected memory cells belonging to the same word line of the selected cell are also turned on, so that currents flow from a power supply through the non-selected memory cells to another power supply (ground). In this case, such non-selected memory cells which are connected to one selected word line are defined as half-selected memory cells. Therefore, since a large number of such half-selected memory cells are connected to one selected word line, power dissipation therefor is large. In addition, even in non-selected memory cells which are connected to non-selected word lines, in order to maintain the memory data stored in the flip-flops of the non-selected memory cells, appropriate hold currents which are, of course, relatively small must flow therethrough. Therefore, since there are also a large number of such non-selected memory cells in the static memory circuit, power dissipation therefore is large.

IBM Technical Disclosure Bulletin, Vo. 17, No. 11, April 1975, page 3336, "Multigated 'dribble' powered MOS FET Storage Cell", discloses a storage cell having a bistable circuit formed of cross coupled MOS FETs. When the circuit is not being addressed the bistable circuit is powered through two series connected resistors. The power supplied through these resistors is sufficient to maintain the state stored in the bistable circuit, but not sufficient for reading or writing. For reading or writing, additional power is supplied to the circuit by turning on an FET device arranged to shunt one of the two resistors.

US—A—3 621 302 discloses a memory cell array divided into portions, each portion containing a plurality of memory cells. Only a portion which is to have one of its cells interrogated is selectively supplied at a high power level, the remaining portions being supplied at a low power level.

It is a principal object of the present invention to provide a static memory circuit with small power dissipation and without reducing the read speed.

According to the present invention, there is provided a static memory circuit comprising:
a first power supply line;
a second power supply line, for carrying a potential which is lower than that which said first power supply line is provided for carrying;
a plurality of word lines;
a plurality of pairs of bit lines;
a plurality of pairs of column selection gate transistors, each pair connected to one of said pairs of bit lines and controlled by column selection signals; and
a plurality of memory cells each one of which comprises a pair of first loads connected to said first power supply line, first and second transistors each having a gate connected to one of the first loads and to a drain of the other of the first and second transistors and having a source connected to a source of the other of the first and second transistors, and third and fourth transistors each having a drain connected to a respective one of said bit lines, a source connected to a respective one of the drains of the first and second transistors and a gate connected to one of said word lines;
characterised by
a plurality of potential setting means, connected to the sources of the first and second transistors of said memory cells and to said second power supply line, for setting the potential of the sources of the first and second transistors of a selected one of the memory cells to be lower than the potentials of the sources of the first and second transistors of non-selected ones of the memory cells,
each of said potential setting means comprising:
a dummy cell having a reference terminal connected to the sources of the first and second transistors of those memory cells belonging to one column; and
a fifth transistor having a drain connected to the dummy cell, a source connected to said second power supply line and a gate for receiving one of the column selection signals,
said dummy cell comprising:

**0 036 775**

a pair of second loads connected to said first power supply line;

sixth and seventh transistors, each having a gate connected to one of the second loads and to a drain of the other of the sixth and seventh transistors and each having a source connected to a source of the other of the sixth and seventh transistors and to the reference terminal; and

a negative feedback circuit comprising eighth and ninth transistors each having a drain connected to the reference terminal, a source connected to said second power supply line and a gate connected to a respective one of the drains of the sixth and seventh transistors.

The present invention will now be more clearly understood from the following description contrasted with the conventional circuit and with reference to the drawings, wherein:

Fig. 1 is a block circuit diagram illustrating one conventional static memory circuit;

Fig. 2 is a circuit diagram of the memory cells, $C_{00}$, $C_{01}$, $C_{10}$ and $C_{11}$ of Fig. 1;

Fig. 3 is a circuit diagram illustrating a static memory circuit which does not form part of the prior art, which does not embody the present invention, but which provides assistance in explaining the invention;

Figs. 4A through 4D are timing diagrams for explaining the operation of the cell $C_{00}$ of Fig. 3;

Fig. 5 is a circuit diagram illustrating an embodiment of the static memory circuit according to the present invention.

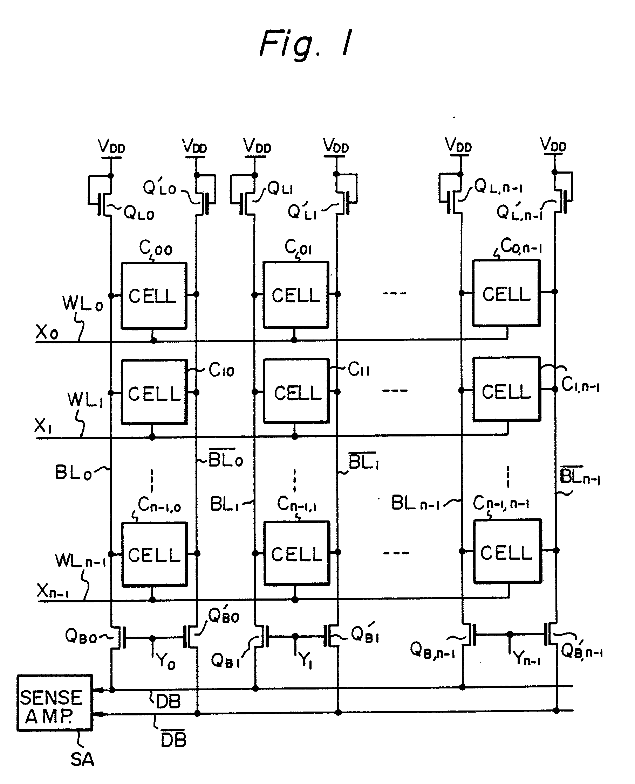

Referring to Fig. 1, which illustrates one conventional static memory circuit, the static memory circuit comprises a plurality of memory cells $C_{ij}$ (i, j=0, 1, . . ., n−1) which are arranged in an n row, n column matrix. Each of the memory cells, for example, the memory cell $C_{00}$, is connected to one word line $WL_0$ which is selected by a row address signal $X_0$ and to one pair of bit lines $BL_0$ $\overline{BL_0}$ which are selected by conducting transistors $Q_{B0}$ and $Q_{B0}'$. In this circuit, the transistors $Q_{B0}$ and $Q_{B0}'$ are column selection gates which are controlled by a column selection signal $Y_0$. In addition, all the bit lines $BL_0$, $\overline{BL_0}$, $BL_1$, $\overline{BL_1}$, . . ., $BL_{n-1}$, $\overline{BL_{n-1}}$ are connected to a power supply $V_{DD}$ through load transistors $Q_{L0}$, $Q_{L0}'$, $Q_{L1}$, $Q_{L1}'$ . . ., $Q_{L,n-1}$, $Q_{L,n-1}'$, respectively, and to data bus lines DB and $\overline{DB}$ connected to a sense amplifier SA through the transistors $Q_{B0}$, $Q_{B0}'$, $Q_{B1}$, $Q_{B1}'$, . . ., $Q_{B,n-1}$, $Q_{B,n-1}'$, respectively.

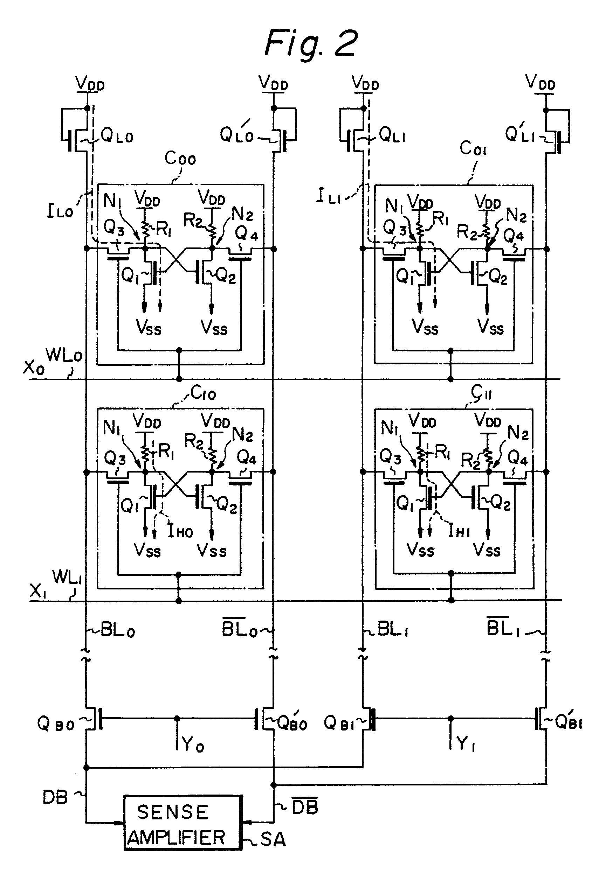

Fig. 2 is a circuit diagram of the memory cells $C_{00}$, $C_{01}$, $C_{10}$ and $C_{11}$ of Fig. 1. In Fig. 2, each of the memory cells, which are, of course, the same as the other memory cells of Fig. 1, comprises a pair of loads $R_1$ and $R_2$, which are resistors, and a pair of transistors $Q_1$ and $Q_2$ cross-coupled to each other, which constitute a flip-flop, and a pair of transfer gate transistors $Q_3$ and $Q_4$. In this case, a drain and a gate of the transistor $Q_1$ are connected to a gate and a drain of the transistor $Q_2$, respectively. In addition, the transfer gate transistors $Q_3$ and $Q_4$ are connected to the bit lines $BL_0$ and $\overline{BL_0}$ (or $BL_1$ and $\overline{BL_1}$), respectively, and the gates of the transistors $Q_3$ and $Q_4$ are

connected to the word line $WL_0$ (or $WL_1$), commonly. In Fig. 2, it should be noted that two gate-drain connected transistors can be used as the load resistors $R_1$ and $R_2$.

The read operation of the circuit of Fig. 2 will now be explained. For example, when it is required to read the data stored in the memory cell $C_{00}$, the potential of the row selection signal $X_0$, that is, the potential of the word line $WL_0$ is caused to be high by a row driver (not shown), so that the transfer gate transistors $Q_3$ and $Q_4$ of the cell $C_{00}$ conduct. As a result, the potentials at nodes $N_1$ and $N_2$ of the cell $C_{00}$ which are dependent upon the memory data "0" or "1" are transmitted to the bit lines $BL_0$ and $\overline{BL_0}$, respectively. In this case, if the transistor $Q_1$ is conductive, as illustrated in Fig. 2, a load current $I_{L0}$ flows from a power supply $V_{DD}$, through the transistor $Q_{L0}$ and the transistors $Q_3$ and $Q_1$ of the cell $C_{00}$ to a power supply $V_{SS}$, so that the potential of the bit line $BL_0$ is decreased. On the other hand, in this case, since the transistor $Q_2$ of the cell $C_{00}$ is non-conductive, no current flows through the transistor $Q_{L0}'$, the transistors $Q_4$ and $Q_2$ of the cell $C_{00}$, so that the potential of the bit line $BL_0$ remains at the same high level which is lower than the power supply $V_{DD}$ by the threshold voltage $V_{th}$ of the transistor $Q_{L0}'$. In addition, when the potential of the column selection signal $Y_0$ is caused to be high by a column driver (not shown) so that the transistors $Q_{B0}$ and $Q_{B0}'$ are turned on, the difference in potential between the bit lines $BL_0$ and $\overline{BL_0}$, that is, the difference in potential between data bus lines DB and $\overline{BB}$ is amplified by the sense amplifier SA.

However, in this state, even in the half-selected memory cell $C_{01}$ connected to the selected high word line $WL_0$ and to the non-conductive transistors $Q_{B1}$ and $Q_{B1}'$, the transfer gate transistors $Q_3$ and $Q_4$ conduct. As a result, a load current $I_{L1}$ as illustrated in Fig. 2 flows from the transistor $Q_{L1}$, and the transistors $Q_3$ and $Q_1$ of the cell $C_{01}$ to the power supply $V_{SS}$, if the potentials at the nodes $N_1$ and $N_2$ of the cell $C_{01}$ are low and high, respectively. In other words, when the potential of one word line is high, the same type of a current flows through each of the half-selected memory cells which belong to said word line.

Further, in each of the non-selected memory cells $C_{10}$ and $C_{11}$, a hold current $I_{H0}$ flows from the power supply $V_{DD}$ through the resistor $R_1$ and the transistor $Q_1$ to the power supply $V_{SS}$, if the potentials at the nodes $N_1$ and $N_2$ thereof are low and high, respectively. Note that such a hold current also flows through both of the selected memory cell $C_{00}$ and the half-selected memory cell $C_{01}$; however, the hold current is much smaller than the load current $I_{L0}$ or $I_{L1}$.

Returning to Fig. 1, usually, the static memory circuit is of a large scale, which is, for example, 4,096 or 16,384 bis. Therefore, in the case of a 4,096 bit (64×64) memory circuit, the above-mentioned load current, which is invalid for the read operation, flows through each of (64-1) half-selected memory cells, while, in the case of a 16,384 bit ($128\times128$) memory circuit, such invalid load current flows through each of (128-1) half-selected memory cells, which results in a large power consumption. For example, if the load current is 0.5 mA per cell, the amount of invalid load currents is 31.5 mA (=$0.5\times63$) in the case of the 4.096 bit memory circuit, while the amount is 63.5 mA ($0.5\times127$) in the case of the 16,384 bit memory circuit. Therefore, in high-integrated memory circuits, it is impossible to neglect the amount of invalid load currents. For this purpose, it is considered to reduce the value of the load current; however, in this case, power for charging the bit lines and the data bus lines DB and $\overline{DB}$ in the read mode is reduced and accordingly, the read speed is reduced. Therefore, usually, the value of the load current is selected to be an appropriately high so as to increase the read speed.

It should be noted that, in non-selected memory cells except for half-selected memory cells, hold currents are preferably as small as possible, which is helpful in reducing power consumption, since the number of such non-selected memory cells are much larger than that of half-selected memory cells. However, the hold current has a lower limit; if the hold current is lower than the lower limit, the memory data stored in the cell, that is, the state of the potentials at the nodes $N_1$ and $N_2$ can not be maintained.

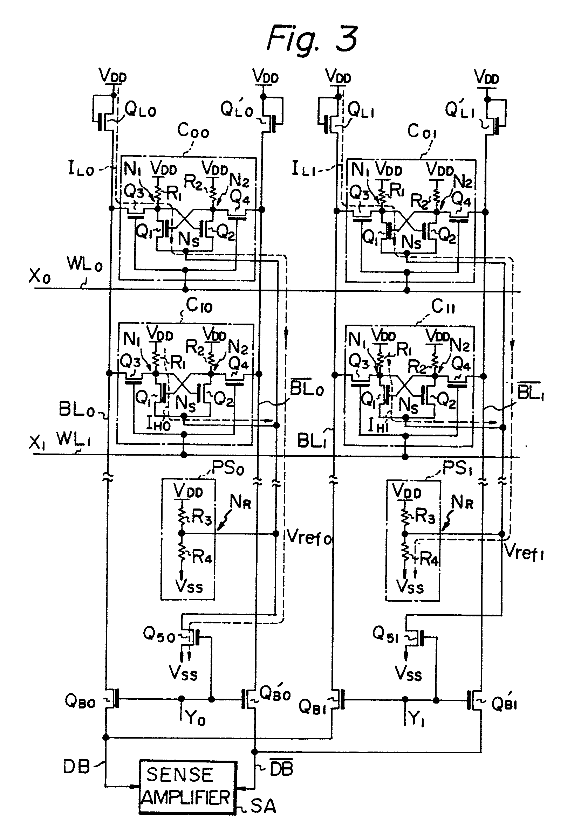

Fig. 3 is a circuit diagram illustrating another static memory circuit. In Fig. 3, the elements which are the same as those of Fig. 2 are denoted by the same references. In each of the memory cells $C_{00}$, $C_{01}$, $C_{10}$ and $C_{11}$, a common source node $N_S$ of the cross-coupled transistors $Q_1$ and $Q_2$ is connected not directly to the power supply $V_{SS}$. That is, the node $N_S$ is connected to a reference node $N_R$ of a potential setting circuit $PS_0$ or $PS_1$ and to a transistor $Q_{50}$ or $Q_{51}$. Each of the potential setting circuits $PS_0$ and $PS_1$ comprises two resistors $R_3$ and $R_4$ connected in series and in addition, the transistor $Q_{50}$ or $Q_{51}$ has a drain connected to the reference node $N_R$ of the circuit $PS_0$ or $PS_1$, a source connected to the power supply $V_{SS}$ and a gate for receiving the column selection signal $Y_0$ or $Y_1$.

The selecting operation of the memory cells is the same as that of Fig. 2. For example, when the potentials of the row selection signals $X_0$ and $X_1$ are high and low, respectively, and simultaneously, the potentials of the column selection signals $Y_0$ and $Y_1$ are high and low, respectively, the memory cells $C_{00}$, $C_{01}$, $C_{10}$ and $C_{11}$ are selected, half-selected, non-selected and non-selected, respectively.

In the selected memory cell $C_{00}$, since the transistor $Q_{50}$ is turned on due to the high potential of the column selection signal $Y_0$, the potental $V_{ref0}$, that is, the potential at the node $N_S$ of the cell $C_{00}$ reaches the same level as the power supply $V_{SS}$. If the transistors $Q_1$ and $Q_2$ are conductive and non-conductive, respectively, a load current $I_{L0}$ flows from the power supply $V_{DD}$

through the transistor $Q_{L0}$, the transistors $Q_3$ and $Q_1$ of the cell $C_{00}$ and the transistor $Q_{50}$ to the power supply $V_{SS}$. At this time, another load current does not flow, since the transistor $Q_2$ of the cell $C_{00}$ is non-conductive. As a result, the potentials of the bit lines $BL_0$ and $\overline{BL_0}$ become low and high respectively, and accordingly, the difference in potential therebetween is read out from the data bus lines DB and $\overline{DB}$ and it is amplified by the sense amplifier SA. It should be noted that, since the potential at the node $N_S$ is the same as that of the power supply $V_{SS}$, the load current $I_{L0}$ is selected to be 0.5 mA in the same way as in Fig. 2, so that the read speed is never reduced.

In the half-selected memory cell $C_{01}$, since the transistor $Q_{51}$ is cut off due to the low potential of the column selection signal $Y_1$, the potential $V_{ref1}$, that is, the potential at the node $N_S$ reaches the same level as the node $R_1$ of the circuit $PS_1$ which is determined by the resistors $R_3$ and $R_4$. Therefore, a load current $I_{L1}$ flows from the power supply $V_{DD}$ and through the transistor $Q_{L1}$, the transistors $Q_3$ and $Q_1$ of the cell $C_{01}$ and the resistor $R_4$ of the circuit $PS_1$ to the power supply $V_{SS}$. In this case, since the potential at the node $N_S$ of the cell $C_{01}$ is higher than that of the cell $C_{00}$, the load current $I_{L1}$ in the half-selected cell $C_{01}$ is smaller than the load current $I_{L0}$ in the selcted cell $C_{00}$. The load current $I_{L1}$ can be reduced by selecting the values of the resistors $R_3$ and $R_4$; however, the load current $I_{L1}$ should not be so small as to maintain the on- and off-states of the flip-flop of the memory cell $C_{01}$; that is, maintain the memory data. For example, if the power supplies $V_{DD}$ and $V_{SS}$ equal 5 and 0 volts, respectively, and the threshold voltage of the transistors $Q_1$ and $Q_2$ is about 0.7 through 1 volts, the upper limit of the potential at the node $N_R$ is about 3.5 volts. In addition, if the potential at the node $N_R$ equals 2 volts, the load current $I_{L1}$ is reduced to be about 0.15 mA and accordingly, current consumptions (0.5—0.15) mA$\times$63 and (0.5—0.15) mA$\times$127 can be saved in a 4,096 bit memory circuit and a 16,384 bit memory circuit, respectively.

In the non-selected memory cells $C_{10}$ and $C_{11}$, hold currents $I_{H0}$ and $I_{H1}$, which are relatively small, flow therethrough. Even in this case, since the potential at the node $N_S$ of the cell $C_{11}$ is higher than that of the cell $C_{10}$, the hold current $I_{H1}$ of the cell $C_{11}$ is smaller than the hold current $I_{H0}$ of the cell $C_{10}$. For example, in a 4,096 bit memory circuit, there are $(64-1)^2$ of non-selected memory cells which correspond to the non-selected cell $C_{11}$. Therefore, the decrease of the hold currents in non-selected cells is helpful to ensure small power consumption.

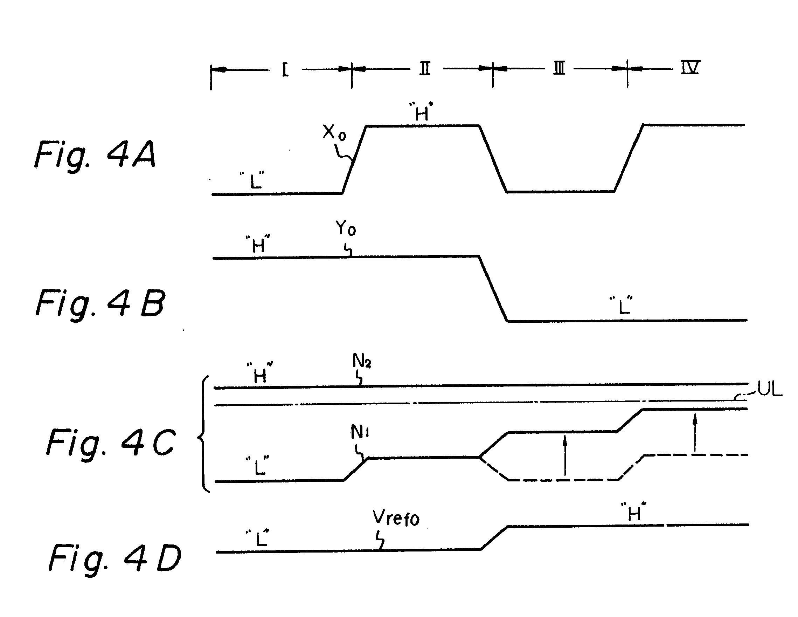

Figs. 4A through 4D are timing diagrams for explaining the operation of the cell $C_{00}$ of Fig. 3. Referring to Figs. 4A and 4B, the memory cell $C_{00}$ has four states indicated by periods I, II, III and IV. In the period I, the potentials of the selection signals $X_0$ and $Y_0$ are low and high, respectively, which means that the cell $C_{00}$ is non-selected. In the period II, the potentials of the selection signals

$X_0$ and $Y_0$ are both high, which means that the cell $C_{00}$ is selected. In the period III, the potentials of the selection signals $X_0$ and $Y_0$ are both low, which means that the cell $C_{00}$ is non-selected. Finally, in the period IV, the potentials of the selection signal $X_0$ and $Y_0$ are high and low, which means that the cell $C_{00}$ is half-selected.

Now, it is assumed that the potentials at the nodes $N_1$ and $N_2$ of the cell $C_{00}$ are low and high, respectively. In this case, the high potential at the node $N_2$ remains at the same level independent of the potentials of the signals $X_0$ and $Y_0$, as illustrated in Fig. 4C. Contrary to this, the potential at the node $N_1$ is dependent upon the potentials of the signal $X_0$ and $Y_0$. That is, as illustrated in Fig. 4C, the potential at the node $N_1$ is higher in the case of the high potential of the signal $X_0$ than in the case of the low potential of the signal $X_0$. In addition, the potential at the node $N_1$ is higher in the case of the low potential of the signal $Y_0$ than in the case of the high potential of the signal $Y_0$, since the potential of the reference voltage $V_{ref0}$ is dependent upon the potential of the signal $Y_0$, as illustrated in Fig. 4D. In Fig. 4C, a dotted line indicates the potential at the node $N_1$ in the conventional circuit of Fig. 2. Therefore, in the periods III and IV, the current consumption can be reduced as compared with the conventional circuit. However, it should be noted that the potential at the node $N_1$ should be not higher than an upper level UL, in order to maintain the memory data of the cell $C_{00}$.

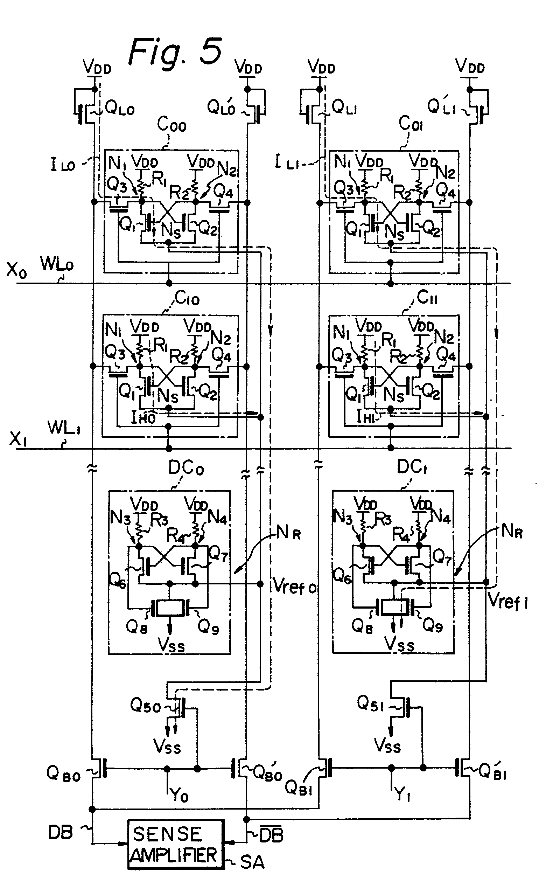

Fig. 5 is a circuit diagram illustrating an embodiment of the static memory circuit according to the present invention. In Fig. 5, the elements which are the same as those of Fig. 3 are denoted by the same references. In Fig. 5, dummy cells $DC_0$ and $DC_1$ are provided for potential setting means instead of the potential setting circuits $PS_0$ and $PS_1$, respectively, of Fig. 3. The dummy cells $DC_0$ and $DC_1$ are similar to the memory cells. That is, each of the dummy cells $DC_0$ and $DC_1$ comprises a pair of load resistors $R_3$ and $R_4$ and a pair of cross-coupled transistors $Q_6$ and $Q_7$ which constitute a flip-flop. In addition, the dummy cell $DC_0$ (or $DC_1$) comprises a negative feedback circuit formed by transistors $Q_8$ and $Q_9$ connected to the above-mentioned flip-flop at the node $N_R$. In more detail, the transistors $Q_8$ and $Q_9$ are arranged between the common source of the transistors $Q_6$ and $Q_7$ and the power supply $V_{SS}$ and in addition, the transistors $Q_8$ and $Q_9$ are controlled by the complementary potentials at the nodes $N_3$ and $N_4$ of the flip-flop.

The operation of the dummy cells $DC_1$ and $DC_2$ is the same as that of the potential setting circuits $PS_0$ and $PS_1$ of Fig. 3. However, as compared with the circuit as illustrated in Fig. 3, the embodiment of the present invention as illustrated in Fig. 5 has an advantage in that the circuit is proof against the fluctuation of the memory operation, since the dummy cell $DC_0$ (or $DC_1$) comprises a flip-flop similar to that of the memory cell, for example, $C_{00}$. Therefore, the fluctuation of the potentials at the nodes $N_1$ and $N_2$ of the memory cell $C_{00}$ (or

$C_{10}$) due to the fluctuation of the power supply $V_{DD}$ or $V_{SS}$ is detected as the fluctuation of the potentials at the nodes $N_3$ and $N_4$ of the dummy cell $DC_0$. In addition, since the potentials at the nodes $N_3$ and $N_4$ which are outputs of the flip-flop control parallel resistances of the transistors $Q_8$ and $Q_9$, so as to maintain the latch condition of the flip-flop in the dummy cell $DC_0$ (or $DC_1$), the decrease of the potential of the power supply $V_{DD}$ also causes the potentials at the nodes $N_3$ and $N_4$ to be reduced and accordingly, said parallel resistances to be increased. As a result, the potential at the node $N_R$ is reduced. Contrary to the above, the increase of the potential of the power supply $V_{DD}$ causes the potential at the node $N_R$ to be increased. Thus, since the potential at the node $N_R$ changes responsive to the fluctuation of the potential of the power supply $V_{DD}$, the difference in potential between the power supply $V_{DD}$ and the node $N_R$ can be definite, even if the potential of the power supply $V_{DD}$ is fluctuated. As a result, destruction of the memory data can be avoided and, in addition, currents such as load currents flowing through half-selected cells and hold currents flowing through non-selected cells can be reduced. In Fig. 5, the reference voltage $V_{ref0}$ (or $V_{ref1}$) can be determined by selecting the values of the resistors $R_3$ and $R_4$, the $g_m$ ratio between the transistors $Q_6$ and $Q_7$, and the $g_m$ ratio between the transistors $Q_8$ and $Q_9$.

As explained hereinbefore, the present invention has an advantage, as compared with the conventional circuit, in that, current dissipation, that is, power dissipation is reduced, since load currents flowing through half-selected memory cells are reduced and, in addition, hold currents flowing through non-selected memory cells are reduced. In the present invention, the read speed is not decreased, since a load current flowing through a selected memory cell is not reduced.

**Claim**

A static memory circuit comprising:
a first power supply line ($V_{DD}$);
a second power supply line ($V_{SS}$), for carrying a potential which is lower than that which said first power supply line is provided for carrying;
a plurality of word lines ($WL_0$, $WL_1$);
a plurality of pairs of bit lines ($BL_0$, $\overline{BL_0}$, $BL_1$, $\overline{BL_1}$);
a plurality of pairs of column selection gate transistors ($Q_{B0}$, $Q_{B0}'$, $Q_{B1}$, $Q_{B1}'$), each pair connected to one of said pairs of bit lines ($BL_0$, $\overline{BL_0}$, $BL_1$, $\overline{BL_1}$) and controlled by column selection signals ($Y_0$, $Y_1$); and
a plurality of memory cells ($C_{00}$, $C_{01}$, $C_{10}$, $C_{11}$) each one of which comprises a pair of first loads ($R_1$, $R_2$) connected to said first power supply line ($V_{DD}$), first and second transistors ($Q_1$, $Q_2$) each having a gate connected to one of the first loads ($R_1$, $R_2$) and to a drain of the other of the first and second transistors ($Q_1$, $Q_2$) and having a source connected to a source of the other of the first and second transistors ($Q_1$, $Q_2$), and third and fourth

transistors ($Q_3$, $Q_4$) each having a drain connected to a respective one of said bit lines ($BL_0$, $\overline{BL_0}$, $BL_1$, $\overline{BL_1}$), a source connected to a respective one of the drains of the first and second transistors ($Q_1$, $Q_2$) and a gate connected to one of said word lines ($WL_0$, $WL_1$);

characterised by

a plurality of potential setting means, connected to the sources of the first and second transistors ($Q_1$, $Q_2$) of said memory cells ($C_{00}$, $C_{01}$, $C_{10}$, $C_{11}$) and to said second power supply line ($V_{SS}$), for setting the potential of the sources of the first and second transistors ($Q_1$, $Q_2$) of a selected one of the memory cells ($C_{00}$, $C_{01}$, $C_{10}$, $C_{11}$) to be lower than the potentials of the sources of the first and second transistors ($Q_1$, $Q_2$) of non-selected ones of the memory cells ($C_{00}$, $C_{01}$, $C_{10}$, $C_{11}$),

each of said potential setting means comprising:

a dummy cell ($DC_0$, $DC_1$) having a reference terminal ($N_R$) connected to the sources of the first and second transistors ($Q_1$, $Q_2$) of those memory cells ($C_{00}$, $C_{10}$, $C_{01}$, $C_{11}$) belonging to one column; and

a fifth transistor ($Q_{50}$, $Q_{51}$) having a drain connected to the dummy cell, ($DC_0$, $DC_1$), a source connected to said second power supply line ($V_{SS}$) and a gate for receiving one of the column selection signals ($Y_0$, $Y_1$),

said dummy cell ($DC_0$, $DC_1$) comprising:

a pair of second loads ($R_3$, $R_4$) connected to said first power supply line ($V_{DD}$);

sixth and seventh transistors ($Q_6$, $Q_7$), each having a gate connected to one of the second loads ($R_3$, $R_4$) and to a drain of the other of the sixth and seventh transistors ($Q_6$, $Q_7$) and each having a source connected to a source of the other of the sixth and seventh transistors ($Q_6$, $Q_7$) and to the reference terminal ($N_R$); and

a negative feedback circuit comprising eighth and ninth transistors ($Q_8$, $Q_9$) each having a drain connected to the reference terminal ($N_R$), a source connected to said second power supply line ($V_{SS}$) and a gate connected to a respective one of the drains of the sixth and seventh transistors ($Q_6$, $Q_7$).

**Patentanspruch**

Statische Speicherschaltung mit:

einer ersten Energieversorgungsleitung ($V_{DD}$);

einer zweiten Energieversorgungsleitung ($V_{SS}$), um ein Potential zu führen, welches niedriger ist als dasjenige ist, das zu führen die erste Energieversorgungsleitung vorgesehen ist;

einer Vielzahl von Wortleitungen ($WL_0$, $WL_1$);

einer Vielzahl von Paaren von Bitleitungen ($BL_0$, $\overline{BL_0}$, $BL_1$, $\overline{BL_1}$);

liner Vielzahl von Paaren von Spaltenauswahlgatetransistoren ($Q_{B0}$, $Q'_{B0}$, $Q_{B1}$, $Q'_{B1}$), von denen jedes Paar mit einem der Paare von Bitleitungen ($BL_0$, $\overline{BL_0}$, $BL_1$, $\overline{BL_1}$) verbunden ist und durch die Spaltenauswahlsignale ($Y_0$, $Y_1$) gesteuert wird; und

einer Vielzahl von Speicherzellen ($C_{00}$, $C_{01}$, $C_{10}$, $C_{11}$), von denen jede ein Paar von ersten Lasten ($R_1$, $R_2$) umfaßt, die mit der genannten ersten Energieversorgungsleitung ($V_{DD}$) verbunden sind, ersten und zweiten Transistoren ($Q_1$, $Q_2$), die jeweils ein Gate haben, das mit einer der ersten Lasten ($R_1$, $R_2$) und einem Drain des anderen der ersten und zweiten Transistoren ($Q_1$, $Q_2$) verbunden ist, und eine Source, die mit einer Source des anderen der ersten und zweiten Transistoren ($Q_1$, $Q_2$) verbunden ist, und dritte und vierte Transistoren ($Q_3$, $Q_4$), die jeweils ein Drain haben, das mit einer entspre- chenden der genannten Bitleitungen ($BL_0$, $\overline{BL_0}$, $BL_1$, $\overline{BL_1}$) verbunden ist, eine Source, die mit dem Drain von einem entsprechenden der ersten und zweiten Transistoren ($Q_1$, $Q_2$) verbunden ist, und ein Gate, das mit einer der genannten Wortleitungen ($WL_0$, $WL_1$) verbunden ist;

gekennzeichnet durch

eine Vielzahl von Potentialeinstelleinrichtungen, die mit den Sourcen der ersten und zweiten Transistoren ($Q_1$, $Q_2$) der genannten Speicherzellen ($C_{00}$, $C_{01}$, $C_{10}$, $C_{11}$) und der genannten zweiten Energieversorgungsleitung ($V_{SS}$) verbunden sind, um das Potential der Sourcen der ersten und zweiten Transistoren ($Q_1$, $Q_2$) einer ausgewählten Speicherzelle ($C_{00}$, $C_{01}$, $C_{10}$, $C_{11}$) einzustellen, damit es niedriger als die Potentiale der Sourcen der ersten und zweiten Transistoren ($Q_1$, $Q_2$) der nicht ausgewählten Speicherzellen ($C_{00}$, $C_{01}$, $C_{10}$, $C_{11}$) ist,

wobei jede Potentialeinstelleinrichtung umfaßt:

eine blinde Zelle ($DC_0$, $DC_1$), die einen Referenzanschluß ($N_R$) hat, der mit den Sourcen der ersten und zweiten Transistoren ($Q_1$, $Q_2$) von jenen Speicherzellen ($C_{00}$, $C_{10}$, $C_{01}$, $C_{11}$) verbunden ist, die zu einer Spalte gehören, und

einen fünften Transistor ($Q_{50}$, $Q_{51}$), der ein Drain hat, das mit der blinden Zelle, ($DC_0$, $DC_1$), verbunden ist, eine Source, die mit der genannten zweiten Energieversorgungsleitung ($V_{SS}$) und einem Gate zum Empfang eines der Spaltenauswahlsignale ($Y_0$, $Y_1$) verbunden ist,

wobei die blinde Zelle ($DC_0$, $DC_1$) umfaßt:

ein Paar von zweiten Lasten ($R_3$, $R_4$), die mit der genannten ersten Energieversorgungsleitung ($V_{DD}$) verbunden sind;

sechste und siebte Transistoren ($Q_6$, $Q_7$), die jeweils ein Gate haben, das mit einer der zweiten Lasten ($R_3$, $R_4$) und einem Drain des anderen der sechsten und siebten Transistoren ($Q_6$, $Q_7$) verbunden ist, und die jeweils eine Source haben, die mit einer Source des anderen der sechsten und siebten Transistoren ($Q_6$, $Q_7$) und mit dem Referenzanschluß ($N_R$) verbunden ist; und

ein Gegenkopplungsschaltung mit achten und neunten Transistoren ($Q_8$, $Q_9$), die jeweils ein Drain haben, das mit dem Referenzanschluß ($N_R$) verbunden ist, eine Source, die mit der genannten zweiten Energieversorgungsleitung ($V_{SS}$) verbunden ist, und ein Gate, das mit einem entsprechenden der Drains der sechsten und siebten Transistoren ($Q_6$, $Q_7$) verbunden ist.

**Revendication**

Circuit de mémoire statique comprenant:

un premier fil de tension d'alimentation ($V_{DD}$);

un second fil de tension d'alimentation ($V_{SS}$), pour acheminer une tension qui est inférieure à celle pour laquelle le premier fil de tension d'alimentation est prévu pour l'acheminer;

un ensemble de fils de mot ($WL_0$, $WL_1$);

un ensemble de paires de fils de bit ($BL_0$, $\overline{BL_0}$, $BL_1$, $\overline{BL_1}$);

un ensemble de paires de transistors de porte de sélection de colonne ($Q_{B0}$, $Q_{B0}'$, $Q_{B1}$, $Q_{B1}'$), chaque paire étant connectée à une des paires de fils de bit ($BL_0$, $\overline{BL_0}$, $BL_1$, $\overline{BL_1}$) et commandée par des signaux de sélection de colonne ($Y_0$, $Y_1$); et

un ensemble de cellules de mémoire ($C_{00}$, $C_{01}$, $C_{10}$, $C_{11}$) dont chacune comprend une paire de premières charges ($R_1$, $R_2$) connectées au premier fil de tension d'alimentation ($V_{DD}$), des premier et deuxième transistors ($Q_1$, $Q_2$) comportant chacun une grille connectée à une des premières charges ($R_1$, $R_2$) et à drain de l'autre des premier et deuxième transistors ($Q_1$, $Q_2$) et comportant une source connectée à une source de l'autre des premier et deuxième transistors ($Q_1$, $Q_2$), et des troisième et quatrième transistors ($Q_3$, $Q_4$) comportant chacun un drain connecté à un fil respectif des fils de bit ($BL_0$, $\overline{BL_0}$, $BL_1$, $\overline{BL_1}$), une source connectée à un drain respectif des drains des premier et deuxième transistors ($Q_1$, $Q_2$) et une grille connectée à un des fils de mot ($WL_0$, $WL_1$);

caractérisé par

un ensemble de moyens de réglage de tension, connectés aux sources des premier et deuxième transistors ($Q_1$, $Q_2$) des cellules de mémoire ($C_{00}$, $C_{01}$, $C_{10}$, $C_{11}$) et au second fil de tension d'alimentation ($V_{SS}$), pour régler la tension des sources des premier et deuxième transistors ($Q_1$, $Q_2$) d'une cellule sélectionnée parmi les cellules de mémoire ($C_{00}$, $C_{01}$, $C_{10}$, $C_{11}$) pour qu'elle soit inférieure aux tensions des sources des premier et deuxième transistors ($Q_1$, $Q_2$) de cellules non sélectionnées des cellules de mémoire ($C_{00}$, $C_{01}$, $C_{10}$, $C_{11}$),

chacun des moyens de réglage de tension comprenant:

une cellule fictive ($DC_0$, $DC_1$) comportant une borne de référence ($N_R$) connectée aux sources des premier et deuxième transistors ($Q_1$, $Q_2$) des cellules de mémoire ($C_{00}$, $C_{10}$, $C_{01}$, $C_{11}$) appartenant à une colonne; et

un cinquième transistor ($Q_{50}$, $Q_{51}$) comportant un drain connecté à la cellule fictive ($DC_0$, $DC_1$), une source connectée au second fil de tension d'alimentation ($V_{SS}$) et une grille pour recevoir un des signaux de sélection de colonne ($Y_0$, $Y_1$),

la cellule fictive ($DC_0$, $DC_1$) comprenant:

une paire de secondes charges ($R_3$, $R_4$) connectées au premier fil de tension d'alimentation ($V_{DD}$);

des sixième et septième transistors ($Q_6$, $Q_7$), comportant chacun une grille connectée à une des secondes charges ($R_3$, $R_4$) et à un drain de l'autre des sixième et septième transistors ($Q_6$, $Q_7$) et comportant chacun une source connectée à une source de l'autre des sixième et septième transistors ($Q_6$, $Q_7$) et à la borne de référence ($N_R$); et

un circuit à réaction négative comprenant des huitième et neuvième transistors ($Q_8$, $Q_9$) comportant chacun un drain connecté à la borne de référence ($N_R$), une source connectée au second fil de tension d'alimentation ($V_{SS}$) et une grille connectée à un drain respectif des drains des sixième et septième transistors ($Q_6$, $Q_7$).

# Fig. 1

Fig. 2

# Fig. 3

0 036 775

*Fig. 4A*

*Fig. 4 B*

*Fig. 4 C*

*Fig. 4 D*

Fig. 5